# EUROPEAN PATENT APPLICATION

(11) **EP 4 746 630 A1**
(43) Date of publication of application: **20.05.2026**
(21) Application number: 25204393.0
(22) Date of filing: 24.09.2025
(51) Int. Cl.: H10D 30/67, H10B 12/00

(54) **SEMICONDUCTOR DEVICE AND MANUFACTURING METHOD THEREOF**

(30) Priority: 06.11.2024 CN 202411587561
(71) Applicant: SwaySure Technology Co., Ltd., Shenzhen (CN)
(72) Inventor: WANG, Jinghao, Shenzhen (CN)
(74) Representative: Klunker IP Patentanwälte PartG mbB

(57) **Abstract**

A semiconductor device and a method for manufacturing the semiconductor device are provided. The semiconductor device includes a substrate and a semiconductor component located on the substrate; the semiconductor component includes a channel structure, a first electrode, a gate electrode, and a second electrode; the first electrode, the gate electrode, and the second electrode are spaced apart and sequentially stacked in a vertical direction. The channel structure comprises a channel layer and a gate insulating layer, the channel layer extends through the gate electrode in the vertical direction and is connected between the first electrode and the second electrode. The gate insulating layer is located between the gate electrode and the channel layer. According to the solution of the present disclosure, the channel layer has better crystallization characteristics while it can have a variety of shape structures.

## Description

### TECHNICAL FIELD

The present disclosure relates to the technical field of the semiconductor, specifically to a semiconductor device and a manufacturing method thereof.

### BACKGROUND

Dynamic Random Access Memory (DRAM) is a semiconductor memory with the advantages such as large capacity and low cost, and has been widely used in various fields. The basic memory unit of conventional DRAM is 1T1C (1Transistor-1Capacitor) memory unit, which requires a transistor and a capacitor.

With the development of three-dimensional memory process, the number of vertical channel transistor structures is increasing. In the transistor with the vertical channel structure, channel layer between the interconnect layers is controlled by the word line (WL) to act as a switch. However, the channel layer in the related art is often limited by a circular ring shape and is prepared after the WL, which results in the poor crystallization characteristics of the channel layer and thereby the declined electrical performance of the memory.

### SUMMARY

The present invention provides a semiconductor device according to the independent claim. Further improvements and embodiments are provided in the dependent claims. A series of simplified concepts is introduced into the portion of Summary, which would be further illustrated in the portion of the detailed description.

In view of the existing problems, a first aspect of the present disclosure provides a semiconductor device, including:
a substrate and a semiconductor component located on the substrate;
the semiconductor component including a channel structure and a first electrode, a gate electrode and a second electrode, wherein the first electrode, the gate electrode and the second electrode are spaced apart and stacked sequentially in a vertical direction, the channel structure includes a channel layer and a gate insulating layer, the channel structure extends through the gate electrode in the vertical direction and is connected between the first electrode and the second electrode, and the gate insulating layer is located between the gate electrode and the channel layer.

Exemplarily, the semiconductor device further includes a first insulating layer prepared in the same layer as the gate insulating layer and extending horizontally between the first electrode and the gate electrode.

Exemplarily, the first insulating layer is in contact with the first electrode.

Exemplarily, the first insulating layer is in contact with the gate electrode.

Exemplarily, a distance between one end of the channel layer connected to the second electrode and the gate electrode is smaller than a distance between one end of the gate insulating layer in contacting with the second electrode and the gate electrode.

Exemplarily, the second electrode includes a first portion in contact with the channel layer, and a second portion located on a side of the first portion away from the channel layer;
the semiconductor device further includes an insulating dielectric layer located between the second portion and the gate electrode, and an orthographic projection of the insulating dielectric layer on the substrate does not overlap with an orthographic projection of the channel structure on the substrate.

Exemplarily, the semiconductor device further includes a first signal line formed integrally with the first electrode and extending in a first horizontal direction, and an orthographic projection of the first electrode on the substrate is located within an orthographic projection of the first signal line on the substrate.

Exemplarily, an orthographic projection boundary of the channel layer on the substrate exceeds the orthographic projection of the first signal line on the substrate; or
an orthographic projection boundary of the channel layer on the substrate partially overlaps with an edge of the orthographic projection of the first signal line on the substrate and does not exceed the orthographic projection of the first signal line.

Exemplarily, an orthographic projection of the channel structure on the substrate includes a ring, and an orthographic projection of the gate electrode on the substrate includes a third portion located inside the ring and a fourth portion located outside the ring.

Exemplarily, an orthographic projection of the channel structure on the substrate includes a plurality of fifth portions; the gate electrode includes a sixth portion surrounding each of the fifth portions, and the sixth portion in the gate electrode is formed integrally.

Exemplarily, orthographic projections of the fifth portions on the substrate are strip-shaped and parallel to each other; or
An orthographic projection of a fifth portion on the substrate is a ring, and the gate electrode further includes a seventh portion located inside the ring.

Exemplarily, the first electrode includes a first contact material layer and a conductor layer, wherein the first contact material layer is located between the conductor layer and the channel layer;
the second electrode includes a second contact material layer.

Another aspect of the present disclosure provides a method for manufacturing a semiconductor device, including the steps of:
providing a substrate;
sequentially preparing a first electrode, a channel layer, a gate insulating layer and a gate electrode on the substrate;
preparing a second electrode on the substrate;
wherein the channel layer extends in a vertical direction and is connected between the first electrode and the second electrode, and the gate insulating layer is located between the gate electrode and the channel layer.

Exemplarily, preparing the channel layer includes:
preparing a semiconductor material layer on the first electrode;
preparing a first patterned mask layer on the semiconductor material layer;
using the first patterned mask layer as a mask to etch the semiconductor material layer to form the channel layer.

Exemplarily, the first patterned mask layer includes at least one portion, and an orthographic projection of the portion on the substrate includes a ring or a rectangle; and/or
an orthographic projection of the first patterned mask layer on the substrate includes a plurality of parallel strips.

Exemplarily, preparing the second electrode includes:
preparing a contact material layer on the semiconductor material layer before preparing the first patterned mask layer;
patterning the contact material layer to form an upper contact portion while etching the semiconductor material layer using the first patterned mask layer as a mask;
wherein the second electrode includes the upper contact portion.

Exemplarily, the method further includes: preparing a first signal line, the first signal line and the first electrode being prepared simultaneously, and an orthographic projection of the first electrode on the substrate being located within an orthographic projection of the first signal line on the substrate;
preparing the gate insulating layer and the gate electrode includes:
preparing a gate insulating material layer that covers the channel layer, the upper contact portion, the first electrode and the first signal line;
preparing a gate electrode material layer that covers the gate insulating material layer;
patterning and etching the gate electrode material layer to form the gate electrode, wherein a surface of a side of the gate electrode away from the substrate is lower than the channel layer;
preparing an insulating dielectric layer that covers the gate insulating material layer and the gate electrode;
removing a portion of the insulating dielectric layer and a portion of the gate insulating material layer to expose the upper contact portion, wherein the gate insulating material layer located on one side of the gate electrode close to the channel layer is formed as the gate insulating layer.

Exemplarily, the preparing the second electrode further includes:
preparing a connection portion at an end of the upper contact portion away from the channel layer after the upper contact portion is exposed, wherein the second electrode further includes the connection portion.

Exemplarily, on an orthographic projection on the substrate:
the first patterned mask layer includes a ring, and the gate electrode includes a portion located inside the ring and a portion located outside the ring; or
the first patterned mask layer includes a plurality of portions, and the gate electrode surrounds each of the portions.

Exemplarily, the method further includes: preparing a first signal line, wherein the first signal line and the first electrode are prepared simultaneously, and an orthographic projection of the first electrode on the substrate is located within an orthographic projection of the first signal line on the substrate; wherein an orthographic projection boundary of the first patterned mask layer on the substrate exceeds an orthographic projection of the first signal line on the substrate, or partially overlaps with an edge of the orthographic projection of the first signal line without exceeding the orthographic projection of the first signal line.

Exemplarily, the first electrode includes a conductor layer and a lower contact portion located on a side of the conductor layer away from the substrate;
after preparing the semiconductor material layer, the method further includes the step of: performing heat treatment so as to reduce impedance between the semiconductor material layer and the lower contact portion.

Exemplarily, after preparing the contact material layer on the semiconductor material layer, the method further includes the step of: performing heat treatment so as to reduce impedance between the semiconductor material layer and the contact material layer.

According to the semiconductor device and method for manufacturing the semiconductor device in the implementations of the present invention, the channel layer has better crystallization characteristics while it can have a variety of shape structures. The channel layer is no longer limited to a circular ring shape, which can enlarge the channel area, facilitate reducing electric leakage and increasing the working current, and thereby enhance the electrical performance of the semiconductor device.

### BRIEF DESCRIPTION OF THE DRAWINGS

The following drawings are hereby incorporated as part of the present disclosure for the understanding of the present disclosure. The embodiments of the present disclosure are illustrated and described in the drawings in order to explain the principles of the present disclosure.

In the drawings:
FIGs. 1A-1N are schematic cross-sectional views of a device obtained by implementing a method sequentially for manufacturing a semiconductor device according to a specific embodiment of the present disclosure, along a first direction and along a second direction;
FIGs. 2A-2G are schematic top views of a device obtained by implementing a method sequentially for manufacturing a semiconductor device according to a specific embodiment of the present disclosure;
FIGs. 3A-3F are schematic views of orthographic projections of a semiconductor device according to a specific embodiment of the present disclosure;
FIG. 4 shows a flowchart of the method for manufacturing a semiconductor device according to a specific embodiment of the present disclosure.

### EXPLANATION OF REFERENCE NUMBERALS

100 - Substrate, 101 - Conductor layer, 102 - Lower contact portion, 103 - Semiconductor material layer,
104 - Contact material layer, 105 - First dielectric layer, 106 - Second dielectric layer,
107 - First patterned mask layer, 108 - Channel layer, 109 - Upper contact portion,
110 - Gate insulating material layer, 111 - Gate electrode material layer,
112 - Second patterned mask layer, 113 - Gate electrode, 114 - Insulating dielectric layer,
115 - Gate insulating layer, 116 - First insulating layer, 117 - Material layer, 118 - Connection portion, 122- first signal line,
130 - Third portion, 140 - Fourth portion, 150 - Fifth portion, 160 - Sixth portion,
170 - Seventh portion.

### DETAILED DESCRIPTION

Embodiments of the invention are those whose scope is within that of the appended claims. Other passages stating embodiments which do not fall under the scope of the appended claims are to be considered as examples. Next, the present disclosure will be described more completely in conjunction with the drawings, in which embodiments of the present disclosure are shown. However, the present disclosure can be implemented in various forms but should not be construed as being limited to the embodiments set forth herein. On the contrary, these embodiments are provided to make the disclosure thorough and complete and the scope of the disclosure be completely delivered to those skilled in the art. In the drawings, the sizes and relative sizes of layers and regions may be exaggerated for clarity. The same reference numerals throughout represent the same elements.

It should be understood that when an element or layer is referred to as "on ...", "adjacent to ...", "connected to" or "coupled to" other elements or layers, it can be directly on, adjacent to, connected to or coupled to other elements or layers, or there can be intermediate elements or layers. On the contrary, when an element is referred to as "directly on ...", "directly adjacent to ...", "directly connected to" or "directly coupled to" other elements or layers, there are no intermediate elements or layers. It will be understood that, although the terms first, second, third, etc. may be used to describe various elements, components, regions, layers and/or parts, these elements, components, regions, layers and/or parts should not be limited by these terms. These terms are only used to distinguish one element, component, region, layer or part from another element, component, region, layer or part. Therefore, without departing from the teachings of the present disclosure, the first element, component, region, layer or part discussed below could be represented as a second element, component, region, layer or part.

Spatial relationship terms such as "under", "beneath", "below", "down", "on" "above", etc., may be used herein to describe the relationships between one element or feature and another element(s) or feature(s) shown in the figures. It should be understood that the spatially relationship terms are intended to encompass different orientations of the device in use and operation in addition to the orientation shown in the figures. For example, if the device in the drawings is flipped, then the elements or features described as "under other elements" or "under" or "below" will be oriented as "on" the other elements or features. Therefore, the exemplary terms "under" and "below" may include both upper and lower orientations. The device may be oriented otherwise (rotated 90 degrees or other orientations) and the spatial descriptors used herein are interpreted accordingly.

The terminology used herein is for the purpose of describing particular embodiments only and is not intended to limit the present disclosure. When they are used herein, the singular forms "a," "an," and "the" are intended to include the plural forms as well, unless the context clearly indicates otherwise. It should still be understood that the terms "comprising" and/or "including", when used in this specification, specify the presence of the features, integers, steps, operations, elements and/or components but not to exclude the presence or addition of one or more other features, integers, steps, operations, elements, components and/or groups. When they are used herein, the terms "and/or" include any or all combinations of related listed items.

Embodiments of the present disclosure are described herein with reference to cross-sectional views as schematic diagrams of ideal embodiments (and intermediate structures) of the present disclosure. In this way, variations in the shapes shown due to, for example, manufacturing techniques and/or tolerances can be expected. Hence, the embodiments of the present disclosure should not be limited to the specific shapes of the regions shown herein, but include shape deviations resulting from, for example, manufacturing. For example, an implanted region shown as a rectangle typically has rounded or curved features and/or an implant concentration gradient at its edges, rather than a binary change from the implanted region to a non-implanted region. Similarly, a buried region formed by implantation may result in some implantation in the region between the buried region and the surface through which the implantation is performed. Therefore, what is shown in the figures is essentially illustrative, and their shapes are not intended to indicate the actual shape of the region of the device and are not intended to limit the scope of the present disclosure.

Unless otherwise defined, all terms (including technical and scientific terms) used herein have the same meaning as commonly understood by those skilled in the technical field of the present disclosure. It will also be understood that terms such as those defined in commonly used dictionaries should be understood to have a meaning consistent with their meaning in the context of the relevant art and/or this specification, and should not be interpreted in an ideal or overly formal sense unless expressly defined as such herein.

In order to understand the present disclosure thoroughly, a detailed step and structure is provided in the following description so as to elucidate the technical solutions presented in the present disclosure. Better embodiments of the present disclosure are illustrated in detail as below. However, the present disclosure may further have other embodiments in addition to these detailed descriptions.

In the manufacturing process of the transistor of the DRAM in the related art, generally, a word line (WL) is first formed, and the WL is then etched to form a channel hole penetrating the WL and filled to form a channel layer. Due to the limitation of the process, the shape of the channel layer formed by this manufacturing process is typically limited to a circular ring, with small channel area of the channel layer and consequently poorer electrical performance. At the same time, when the filled channel layer is subjected to heat treatment, the crystallization characteristics of the channel layer are poor. The above two problems will lead to the degradation of the electrical performance of the memory.

Therefore, in view of the existence of the aforementioned technical problems, the present disclosure provides a semiconductor device, including:
a substrate and a semiconductor component located on the substrate;
wherein the semiconductor component includes a channel structure and a first electrode, a gate electrode and a second electrode; the first electrode, the gate electrode and the second electrode are spaced apart and stacked sequentially in a vertical direction, the channel structure includes a channel layer and a gate insulating layer, the channel structure extends through the gate electrode in the vertical direction and is connected between the first electrode and the second electrode, and the gate insulating layer is located between the gate electrode and the channel layer.

Regarding the semiconductor device of the present disclosure, the channel layer can be prepared before the gate electrode so that it can have better crystallization characteristics while it can have a variety of shape structures. The channel layer is no longer limited to a circular ring shape, which can enlarge the channel area, facilitate reducing electric leakage and increasing the working current, and thereby enhance the electrical performance of the semiconductor device.

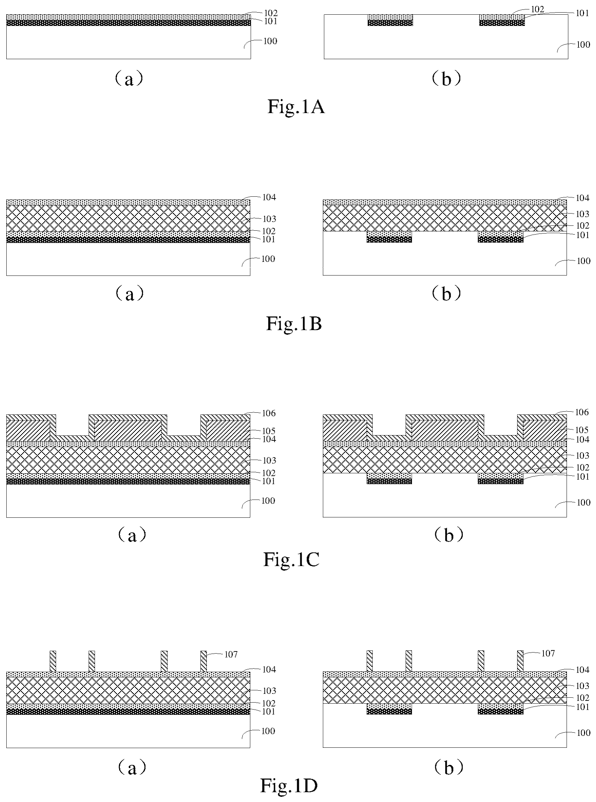

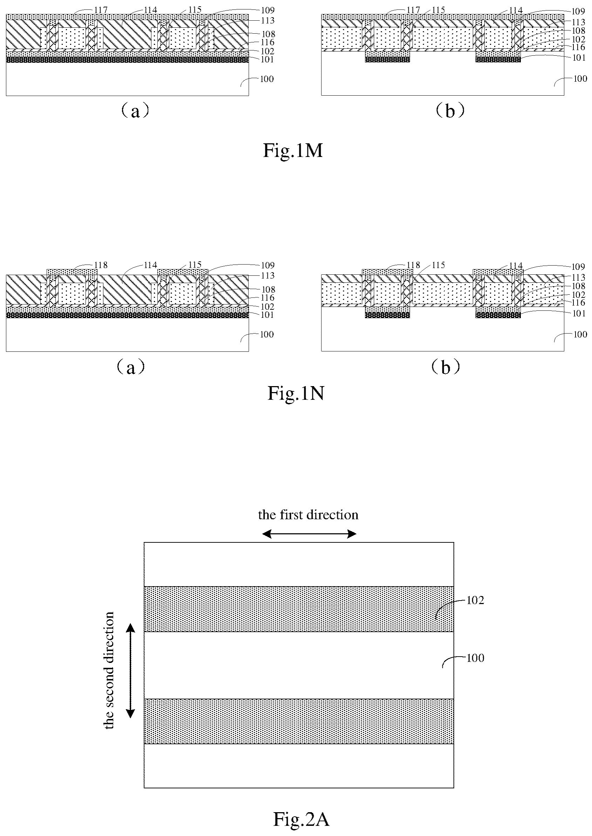

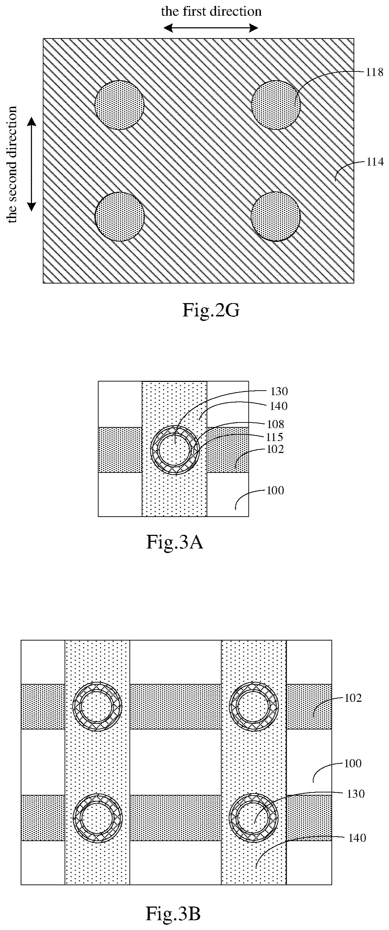

The semiconductor device of the present disclosure is described in details below with reference to FIGs. 1A to 3F, wherein FIGs. 1A to 1N are schematic cross-sectional views of a device obtained by implementing sequentially a method for manufacturing a semiconductor device according to a specific embodiment of the present disclosure, along a first direction and along a second direction; FIGs. 2A to 2G are schematic top views of a device obtained by implementing sequentially the method for manufacturing a semiconductor device according to a specific embodiment of the present disclosure; and FIGs. 3A to 3F are schematic views of orthographic projections of a semiconductor device according to a specific embodiment of the present disclosure. Exemplarily, (a) in FIGs. 1A to 1N shows a schematic cross-sectional view of a semiconductor device along a first direction, and (b) in FIGs. 1A to 1N shows a schematic cross-sectional view of a semiconductor device along a second direction, wherein the first direction intersects with the second direction, and optionally the first direction is perpendicular to the second direction. Exemplarily, the semiconductor device of the embodiment of the present disclosure may be manufactured using the method for manufacturing the semiconductor device described below.

The semiconductor device of the present disclosure may be any suitable type of device known to those skilled in the art. In this embodiment, the technical solution of the present disclosure is explained and illustrated mainly by taking the case where the semiconductor device is a DRAM as an example.

In one example, as shown in FIG. 1N, the semiconductor device of the present disclosure includes a substrate 100, which is a substrate with at least surface insulated, and at least the surface is insulated from the first electrode. The substrate 100 may be an entirely insulated substrate or a composite substrate including a surface insulation layer and a semiconductor substrate. The semiconductor substrate may have transistors formed therein. Although several examples of the substrate 100 are described herein, any material/structure that can be used as a substrate falls within the spirit and scope of the present disclosure.

In one example, as shown in FIG. 1N, the semiconductor device of the present disclosure further includes a semiconductor component located on the substrate 100, the semiconductor component includes a channel structure, a first electrode, a gate electrode 113 and a second electrode, the first electrode, the gate electrode 113 and the second electrode are spaced apart and sequentially stacked in a vertical direction, the channel structure includes a channel layer 108 and a gate insulating layer 115, the channel structure extends through the gate electrode 113 in the vertical direction and is connected between the first electrode and the second electrode, the gate insulating layer 115 is located between the gate electrode 113 and the channel layer 108. Exemplarily, a signal line electrically connected to the gate electrode 113, such as a word line WL, extends in a second horizontal direction.

The vertical direction includes two directions: one perpendicular to the substrate 100 and away from it, and the other perpendicular to the substrate 100 and pointing toward it. When the semiconductor component is manufactured on the substrate 100, or is manufactured on a temporary substrate and then transferred to the substrate 100 in the same direction, the vertical direction is away from the substrate 100; when the semiconductor device is manufactured on the temporary substrate and then transferred to the substrate 100 in a flipped direction the vertical direction is pointing toward the substrate 100.

The channel structure is connected between the first electrode and the second electrode, and at least includes a channel layer 108 connected between the first electrode and the second electrode. Optionally, a gate insulating layer 115 is also connected between the first electrode and the second electrode.

In one example, as shown in FIG. 1N, the first electrode includes a lower contact portion 102 and a conductor layer 101, and the lower contact portion 102 is located between the conductor layer 101 and the channel layer 108. Exemplarily, the material of the conductor layer 101 includes but is not limited to tungsten, polysilicon, doped polysilicon, tantalum nitride, tantalum, copper, etc. Exemplarily, the lower contact portion 102 is disposed corresponding to the conductor layer 101 for reducing a resistance of the electrical connection channel between the conductor layer 101 and the channel layer 108. The lower contact portion 102 may include a contact material layer, the material of the lower contact portion 102 may include but not limited to cobalt silicide, nickel silicide, titanium silicide, tungsten silicide, doped polysilicon, etc., on which the present disclosure does not pose any limitation, and a material combination of the channel layer 108, the conductor layer 101, and the lower contact portion 102 can be set according to actual needs.

In one example, the second electrode includes a first portion in contact with the channel layer 108, and a second portion located on a side of the first portion away from the channel layer 108. More specifically, as shown in FIG. 1N, the second electrode includes an upper contact portion 109 and a connection portion 118, wherein the upper contact portion 109 is the first portion of the second electrode in contact with the channel layer 108, and the connection portion 118 is the second portion of the second electrode located on the side of the first portion away from the channel layer 108.

Exemplarily, the materials of the upper contact portion 109 and the connection portion 118 may be the same or different. The upper contact portion 109 may include a contact material layer, and the material of the upper contact portion 109 may include but not limited to cobalt silicide, nickel silicide, titanium silicide, tungsten silicide, doped polysilicon, etc. When the materials of the upper contact portion 109 and the connection portion 118 are different, the material of the connection portion 118 may include but not limited to tungsten, polysilicon, doped polysilicon, tantalum nitride, tantalum, copper, etc., wherein the upper contact portion 109 is used to reduce a resistance of an electrical connection channel between the channel layer 108 and the connection portion 118; or the connection portion 118 may also include a contact material layer, the material of the connection portion 118 may include but not limited to cobalt silicide, nickel silicide, titanium silicide, tungsten silicide, doped polysilicon, etc. Exemplarily, the lower contact portion 102, the upper contact portion 109 and the connection portion 118 have the same material, and all include contact material layers; or the lower contact portion 102 and the second electrode both include contact material layers, but the materials are different.

Exemplarily, the upper contact portion 109 has the same shape as the channel layer 108 (i.e., has the same horizontal cross-sectional shape), as shown in FIG. 2G, the shape of the connection portion 118 may be circular, or the shape of the connection portion 118 may also be rectangular or long strip. Exemplarily, the connection portions 118 above different channel layers 108 are independently disposed, and the connection portions 118 can be used to increase the contact area and reduce the resistance. Exemplarily, the connection portion 118 is independently connected to a storage structure above. Taking the semiconductor device as a DRAM memory including a 1T1C unit structure as an example, each connection portion 118 may be connected to a capacitor (storage structure). Exemplarily, the semiconductor device of the present disclosure is not limited to the 1T1C structure, and can also be applied to memories of other unit structures (for example, 1T3C, 2T0C, etc.), on which the present disclosure does not pose any limitation. Exemplarily, the first electrode is equivalent to the source electrode of the transistor, the gate electrode 113 is equivalent to the gate electrode of the transistor, and the second electrode can serve as the drain electrode of the transistor, and the second electrode (the connection portion 118 in the second electrode) is directly connected to the capacitor (taking the 1T1C unit structure as an example); or another film layer may be formed on the second electrode to serve as the drain electrode of the transistor, to which the present disclosure is not limited.

In one example, as shown in FIG. 1N, the semiconductor device further includes a first insulating layer 116, which is prepared in the same layer as the gate insulating layer 115 and extends horizontally between the first electrode and the gate electrode 113. Specifically, the first insulating layer 116 is located between the lower contact portion 102 and the gate electrode 113. Exemplarily, the materials of the gate insulating layer 115 and the first insulating layer 116 include but are not limited to silicon oxide, silicon oxynitride, etc. Exemplarily, the first insulating layer 116 is in contact with the first electrode. Exemplarily, the first insulating layer 116 is in contact with the gate electrode 113.

In one example, as shown in FIG. 1N, the spacing between one end of the channel layer 108 in contacting with the second electrode (i.e., one end of the channel layer 108 in contacting with the upper contact portion 109) and the gate electrode 113 is smaller than the spacing between one end of the gate insulating layer 115 in contacting with the second electrode (i.e., one end of the gate insulating layer 115 in contacting with the connection portion 118) and the gate electrode 113. The spacing here refers to the distance in the vertical direction.

In one example, as shown in FIG. 1N, the semiconductor device of the present disclosure further includes an insulating dielectric layer 114 located between the second portion of the second electrode (i.e., the connection portion 118) and the gate electrode 113, and an orthographic projection of the insulating dielectric layer 114 on the substrate 100 does not overlap with an orthographic projection of the channel structure on the substrate 100. Exemplarily, the insulating dielectric layer 114 covers the gate electrode 113 and the channel structure. Exemplarily, the insulating dielectric layer 114 may be made of conventional insulating materials, such as silicon oxide, silicon nitride, silicon oxynitride, low dielectric constant materials, etc., on which the present disclosure does not pose any limitation.

In one example, the semiconductor device further includes a first signal line formed integrally with the first electrode and extending in the first horizontal direction, and an orthographic projection of the first electrode on the substrate 100 is located within an orthographic projection of the first signal line on the substrate 100. Exemplarily, the first electrode is disposed corresponding to the first signal line and two edges of orthographic projections of the first electrode and the first signal line on the substrate 100 completely overlap, but not limited thereto. In some embodiments, the orthographic projection of the first electrode on the substrate 100 is completely within the range of the orthographic projection of the first signal line and does not overlap with the edge of the orthographic projection of the first signal line.

Exemplarily, the signal line of the first signal line electrically connected to the first electrode includes the same structure as the first electrode, i.e., the conductor layer and the lower contact portion located on one side of the conductor layer close to the channel layer 108. It can be understood that only the materials and film structures are the same, to which the present disclosure is not limited. In some embodiments, the first signal line only includes a conductor layer in the same layer as the conductor layer 101, which can be determined according to specific circumstances.

Exemplarily, in a semiconductor device that includes a DRAM memory with an array arrangement of 1T1C memory cell structures, the first signal line is a bit line (BL).

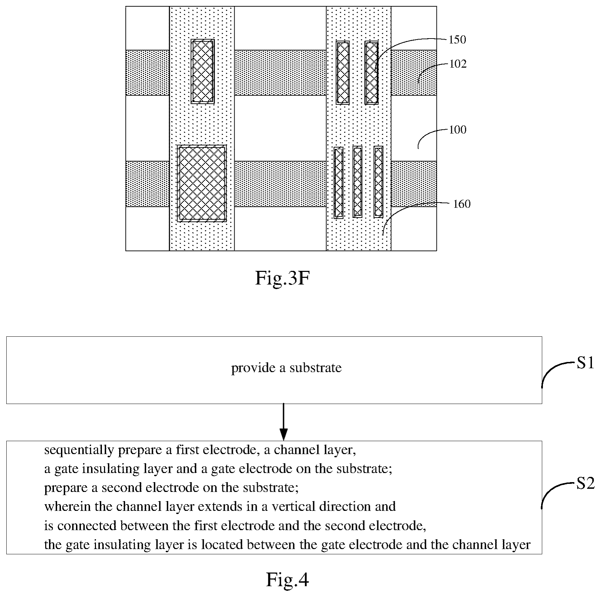

In one example, as shown in FIG. 3F, an orthographic projection boundary of the channel layer 108 on the substrate 100 exceeds an orthographic projection of the lower contact portion 102 on the substrate 100, that is, the orthographic projection boundary of the channel layer 108 on the substrate 100 exceeds the orthographic projection of the first electrode on the substrate 100. The first electrode is formed integrally with the first signal line, and an orthographic projection boundary of the channel layer 108 on the substrate 100 exceeds an orthographic projection of the first signal line on the substrate 100.

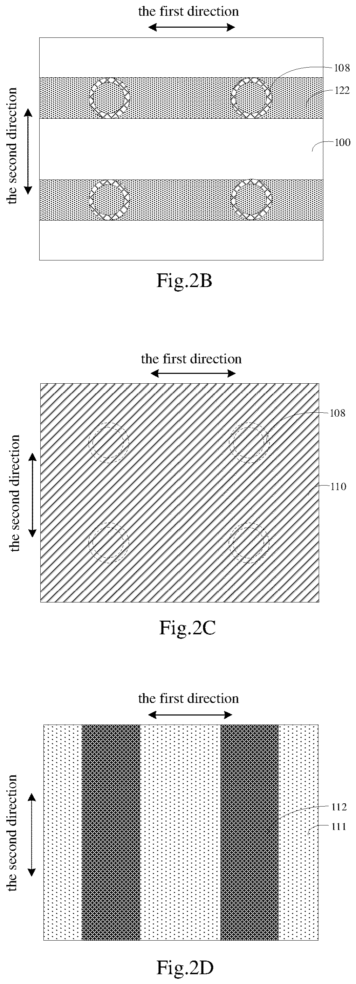

Optionally, the orthographic projection boundary of the channel layer 108 on the substrate 100 just overlaps with a portion of the edge of the orthographic projection of the first signal line without exceeding the boundary of the orthographic projection of the first signal line, as shown in FIG. 2B.

Exemplarily, the orthographic projection boundary of the channel layer 108 on the substrate 100 does not exceed an orthographic projection of the gate electrode 113 on the substrate 100.

In one example, as shown in FIG. 3A and FIG. 3B, the orthographic projection of the channel structure on the substrate 100 includes a ring, and the orthographic projection of the gate electrode 113 on the substrate 100 includes a third portion 130 located inside the ring and a fourth portion 140 located outside the ring. Referring to FIG. 1N, the insulating dielectric layer 114 also includes a portion located inside the ring, and the insulating dielectric layer 114 is located between the gate electrode 113 and the connection portion 118 in the vertical direction.

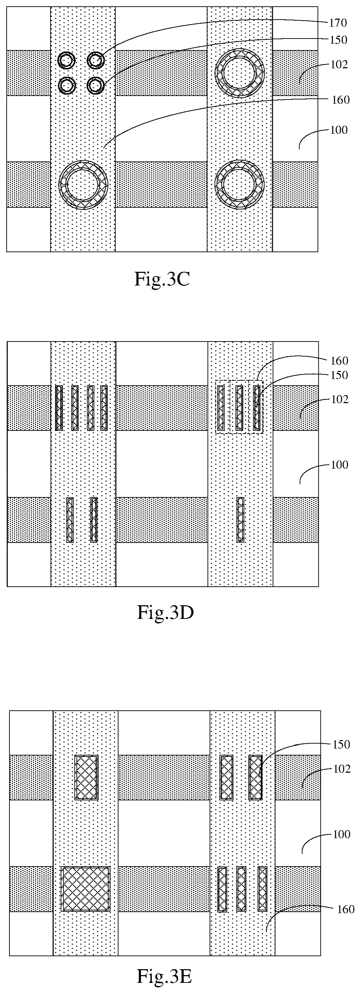

In one example, as shown in FIGs. 3C to 3F, the orthographic projection of the channel structure on the substrate 100 includes a plurality of fifth portions 150, the gate electrode 113 includes a sixth portion 160 surrounding each of the fifth portions 150, and the sixth portion 160 in the gate electrode 113 is formed integrally.

Specifically, as shown in FIGs. 3D, 3E and 3F, the orthographic projections of the fifth portions 150 on the substrate 100 are strip-shaped and parallel to each other; or as shown in FIG. 3C, the orthographic projections of the fifth portions 150 on the substrate 100 are ring-shaped, and the gate electrode 113 further includes seventh portions 170 located inside the rings.

In one example, as shown in FIGs. 3E and 3F, the orthographic projection of the channel structure on the substrate 100 includes a rectangle.

Exemplarily, the orthographic projection of the channel structure on the substrate 100 is entirely located within the orthographic projection range of the gate electrode 113 while is at least partially located within the orthographic projection range of the first electrode.

When the channel structure is prepared before the gate electrode, good crystallization characteristics can be obtained, thereby improving electrical performance. Further, when the orthographic projection of the channel structure on the substrate 100 is a plurality of strips, it can increase the control area of the gate electrode, enlarge the channel area, reduce the leakage current and enhance the working current, or when the orthographic projection of the channel structure on the substrate 100 is ring-shaped, a uniform current distribution can be obtained. Furthermore, when the orthographic projection of the channel structure on the substrate 100 is a plurality of rings, it can increase the control area of the gate electrode, enlarge the channel area while the uniform current distribution is obtained. In some embodiments not shown, the orthographic projection of the channel structure on the substrate also includes a plurality of solid circles or a plurality of rectangles, and the present disclosure does not limit the specific shape of the orthographic projections of the fifth portions 150 on the substrate 100.

In one example, the semiconductor device of the present disclosure may be connected to the storage structure above it to form a memory. Taking the 1T1C unit structure as an example, when it is necessary to read the information stored in a certain unit structure, it only needs to pass a high level to the word line of the unit, and the level state of the capacitor of the unit will be added to a corresponding bit line. The bit line is connected to a read-write drive circuit, and the level state of the capacitor can be read by the read-write drive circuit to complete the reading of the information; or the read-write drive circuit outputs a high level or a low level to charge or discharge the capacitor to complete the writing of the information.

The introduction to the semiconductor device of the present disclosure has been completed. For a complete semiconductor device, there may further include other component structures, which will not be repeated here.

Given above, according to the semiconductor device of the present disclosure, the channel layer has better crystallization characteristics while it can have a variety of shape structures. The channel layer is no longer limited to a circular ring shape, which can enlarge the channel area, facilitate reducing electric leakage and increasing the working current, and thereby enhance the electrical performance of the semiconductor device.

The method for manufacturing the semiconductor device of the present disclosure is described in details below with reference to FIGs. 1A to 4, wherein FIGs. 1A to 1N are schematic cross-sectional views of a device obtained by implementing a method for manufacturing a semiconductor device sequentially according to a specific embodiment of the present disclosure, along a first direction and in a second direction; FIGs. 2A to 2G are schematic top views of a device obtained by implementing the method for manufacturing a semiconductor device sequentially according to a specific embodiment of the present disclosure; FIGs. 3A to 3F are schematic views of orthographic projections of a semiconductor device according to a specific embodiment of the present disclosure; and FIG. 4 shows a flowchart of the method for manufacturing a semiconductor device according to a specific embodiment of the present disclosure. Exemplarily, (a) in FIGs. 1A to 1N shows a schematic cross-sectional view of a semiconductor device along a first direction, and (b) in FIGs. 1A to 1N shows a schematic cross-sectional view of a semiconductor device along a second direction, wherein the first direction intersects with the second direction, and optionally the first direction is perpendicular to the second direction.

Exemplarily, as shown in FIG. 4, the method for manufacturing a semiconductor device of the present disclosure includes the steps S1 and S2 as follows.

First, step S1 is performed to provide a substrate 100, as shown in FIG. 1A.

The semiconductor device of the present disclosure may be any suitable type of device known to those skilled in the art. In this embodiment, the technical solution of the present disclosure is explained and illustrated mainly by taking the case where the semiconductor device is a DRAM as an example.

In one example, the substrate 100 is a substrate with at least surface insulated, and at least the surface is insulated from the first electrode. The substrate 100 may be an entirely insulated substrate or a composite substrate including a surface insulation layer and a semiconductor substrate. The semiconductor substrate has a transistor formed therein. Although several examples of the substrate 100 are described herein, any material/structure that can be used as a substrate falls within the spirit and scope of the present disclosure.

Next, step S2 is performed: sequentially preparing a first electrode, a channel layer, a gate insulating layer and a gate electrode on the substrate 100; preparing a second electrode on the substrate 100; wherein the channel layer extends in a vertical direction and is connected between the first electrode and the second electrode, and the gate insulating layer is disposed between the gate electrode and the channel layer.

In one example, as shown in FIG. 1A and FIG. 2A, the first electrode is first prepared. The first electrode includes a conductor layer 101 and a lower contact portion 102 located on one side of the conductor layer away from the substrate 100. Exemplarily, the material of the conductor layer 101 includes but is not limited to tungsten, polysilicon, doped polysilicon, tantalum nitride, tantalum, copper, etc. Exemplarily, the lower contact portion 102 is disposed corresponding to the conductor layer 101. The material of the lower contact portion 102 includes but is not limited to cobalt silicide, nickel silicide, titanium silicide, tungsten silicide, doped polysilicon, etc. Exemplarily, the conductor layer 101 and the lower contact portion 102 may be formed by a deposition method commonly used in the art, for example, they may be formed by a chemical vapor deposition (CVD) method, a physical vapor deposition (PVD) method, or an atomic layer deposition (ALD) method, etc., on which the present disclosure does not pose any limitation.

In one example, the method of the present disclosure further includes: preparing a first signal line, the first signal line and the first electrode are prepared simultaneously, and an orthographic projection of the first electrode on the substrate 100 is located within an orthographic projection of the first signal line on the substrate 100. Exemplarily, the first signal line is formed integrally with the first electrode and extends in the first horizontal direction, and the first signal line is a bit line (BL). Exemplarily, an edge of the orthographic projection of the first electrode on the substrate 100 coincides with an edge of the orthographic projection of the first signal line.

Optionally, the method further includes forming an insulating layer between first electrodes and making the surface of the insulating layer flush with the first electrodes. The insulating layer is formed as a part of the substrate 100.

In one example, after the first electrode is formed, the channel layer is prepared. Specifically, as shown in FIGs. 1B to 1E and 2B, preparing the channel layer 108 includes the following steps.

First, as shown in FIG. 1B, a semiconductor material layer 103 is prepared on the first electrode and covers the surface of the first electrode and the substrate 100. Exemplarily, after the semiconductor material layer 103 is prepared, the method of the present disclosure further includes the step of: performing heat treatment to reduce impedance between the semiconductor material layer 103 and the lower contact portion 102. Meanwhile, the heat treatment process can also change the crystallization characteristics of the semiconductor material layer 103, for example, when the semiconductor material layer 103 includes amorphous silicon, the amorphous silicon can be converted into crystalline silicon, such as polycrystalline silicon, by the heat treatment process. The above-mentioned heat treatment can adopt various known heat treatment processes in the art, such as rapid thermal annealing, etc. Since the semiconductor material layer 103 used to prepare the channel layer 108 is prepared before the gate electrode, its heat treatment can make it have better crystallization characteristics.

Next, as shown in FIG. 1D, a first patterned mask layer 107 is prepared on the semiconductor material layer 103.

Taking the preparation of the annular channel layer 108 as an example, as shown in FIG. 1C and FIG. 1D, preparing the first patterned mask layer 107 includes: sequentially preparing a first dielectric layer 105 and a second dielectric layer 106 on the semiconductor material layer 103, wherein a plurality of vias exposing the semiconductor material layer 103 are formed in the first dielectric layer 105, and the second dielectric layer 106 covers the bottom and side walls of the vias and the surface of the first dielectric layer 105; then removing the second dielectric layer 106 at the bottom of the vias and on the surface of the first dielectric layer 105, retaining the second dielectric layer 106 located on the side walls of the vias as the first patterned mask layer 107, and removing the first dielectric layer 105, on which the present disclosure does not pose any limitation, as long as the annular first patterned mask layer 107 can be formed.

Exemplarily, the thickness of the formed channel layer 108 in the horizontal direction can be defined by defining the thickness of the first patterned mask layer 107 in the horizontal direction, that is, by controlling the deposition thickness of the second dielectric layer 106. Exemplarily, the first dielectric layer 105 and the second dielectric layer 106 can be made of conventional insulating materials, such as silicon oxide, silicon nitride, silicon oxynitride, etc., as long as they are guaranteed to have a suitable etching selectivity ratio, on which the present disclosure does not pose any limitation.

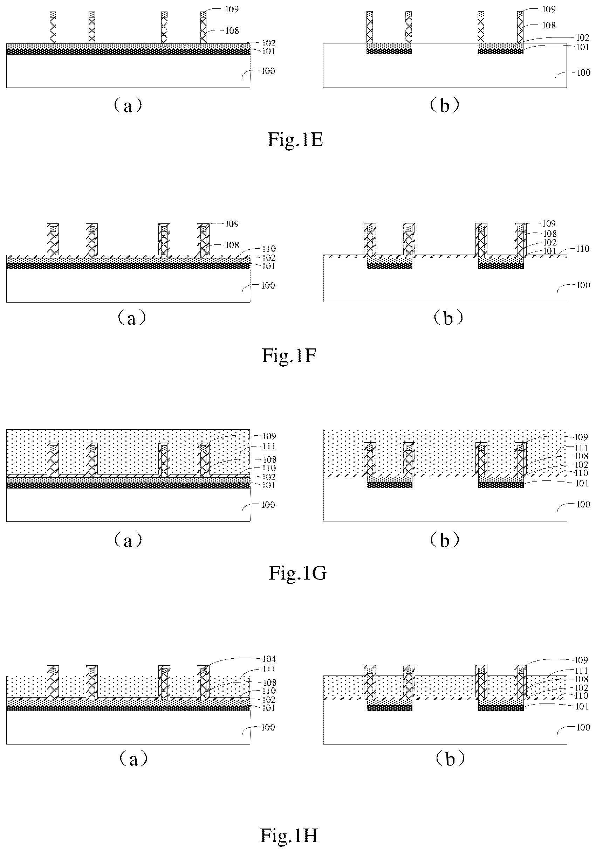

Next, as shown in FIG. 1E, the semiconductor material layer 103 is etched using the first patterned mask layer 107 as a mask to form a channel layer 108. Exemplarily, various etching processes commonly used in the art may be used to etch the semiconductor material layer 103 using the first patterned mask layer 107 as a mask, on which the present disclosure does not pose any limitation. It is understood that the shape of the formed channel layer 108 can be defined by defining the shape of the first patterned mask layer 107, that is, the channel layer 108 has the same shape as the first patterned mask layer 107 in the orthographic projections on the substrate 100.

In one example, the orthographic projection of the first patterned mask layer 107 on the substrate 100 coincides with the orthographic projection of the channel layer 108 on the substrate 100. As shown in FIGs. 3A to 3F, the orthographic projection of the channel layer 108 on the substrate 100 may include at least one portion, the orthographic projection of the portion on the substrate 100 includes a ring or a rectangle; and/or, the orthographic projection of the channel layer 108 on the substrate 100 includes a plurality of parallel strips. That is, the orthographic projection of the first patterned mask layer 107 on the substrate 100 may include at least one portion, the orthographic projection of the portion on the substrate 100 includes a ring or a rectangle; and/or, the orthographic projection of the first patterned mask layer 107 on the substrate 100 includes a plurality of parallel strips.

In one example, the orthographic projection boundary of the first patterned mask layer 107 on the substrate 100 may exceed the orthographic projection of the first signal line on the substrate 100, that is, the orthographic projection of the first patterned mask layer 107 on the substrate 100 only needs to be at least partially located within the orthographic projection of the first signal line.

In one example, an orthographic projection boundary of the annular first patterned mask layer 107 on the substrate 100 partially overlaps with an edge of an orthographic projection of the first signal line on the substrate 100, as shown in FIG. 2B, that is, an orthographic projection boundary of the annular channel layer 108 on the substrate 100 partially overlaps with the edge of the orthographic projection of the first signal line.

It can be understood that in the prior art, after etching the gate to form a channel hole, a gate insulating layer and a channel layer are sequentially prepared in the channel hole. In order to reduce defects at the bottom of the etched channel hole, the bottom surface of the channel hole is usually completely located in the signal line, so that the channel width is small and the electrical performance is declined. The present disclosure can further expand the channel width by first making the channel layer and then making the gate insulating layer and the gate electrode. This can allow the boundary of the channel layer to overlap with, or even exceed, the signal line, thereby enhancing the electrical performance of the semiconductor device, i.e., the transistor.

In one example, as shown in FIG. 1B to FIG. 1E, preparing the second electrode includes: preparing a contact material layer 104 on the semiconductor material layer 103 before preparing the first patterned mask layer 107; patterning the contact material layer 104 to form an upper contact portion 109 while etching the semiconductor material layer 103 using the first patterned mask layer 107 as a mask; the second electrode includes the upper contact portion 109. Exemplarily, the material of the upper contact portion 109 includes but is not limited to cobalt silicide, nickel silicide, titanium silicide, tungsten silicide, doped polysilicon, and the like.

In one example, after the contact material layer 104 is prepared on the semiconductor material layer 103, the method of the present disclosure further includes: performing heat treatment to reduce the impedance between the semiconductor material layer 103 and the contact material layer 104. Exemplarily, after the semiconductor material layer 103 is formed on the lower contact portion 102, the heat treatment may not be performed first, and it may be performed after the contact material layer 104 is prepared, so as to simultaneously reduce the impedance between the semiconductor material layer 103 and the contact material layer 104 and the impedance between the semiconductor material layer 103 and the lower contact portion 102, and improve the crystallization characteristics of the semiconductor material layer 103.

In one example, the present disclosure performs a heat treatment process after forming the semiconductor material layer 103 (when forming the contact material layer 104, the heat treatment process is performed after the contact material layer 104 is formed). Compared with the related art of filling the holes obtained by etching the WL control layer with channel materials to form the channel layer and then performing the heat treatment process, the channel layer 108 of the present disclosure has better crystallization characteristics and lower impedance with the upper contact portion 109 and the lower contact portion 102, thereby improving the electrical performance of the device.

In one example, the present disclosure first forms the semiconductor material layer 103 and then etches the semiconductor material layer 103 to obtain the channel layer 108, which can improve the shape structures of the channel layer 108, so that the channel layer 108 is no longer limited to a circular ring shape. For example, it can also be a plurality of long strips, etc., which can enlarge the channel area, reduce leakage and increase the working current, and thereby enhance the electrical performance of the device.

In one example, after the channel layer 108 is formed, preparing the gate insulating layer 115 and the gate electrode 113 includes:
First, as shown in FIG. 1F and FIG. 2C, a gate insulating material layer 110 is prepared and covers the channel layer 108, the upper contact portion 109, the first electrode, and the first signal line. Exemplarily, the gate insulating material layer 110 may be formed by a deposition method commonly used in the art, for example, it may be formed by a chemical vapor deposition (CVD) method, a physical vapor deposition (PVD) method, or an atomic layer deposition (ALD) method, etc., on which the present disclosure does not pose any limitation. Exemplarily, the material of the gate insulating material layer 110 includes but is not limited to silicon oxide, silicon oxynitride, etc.

Exemplarily, the first insulating layer 116 and the gate insulating layer 115 are prepared simultaneously.

Next, as shown in FIG. 1G, a gate electrode material layer 111 is prepared and covers the gate insulating material layer 110. Exemplarily, the gate electrode material layer 111 may be formed by a deposition method commonly used in the art, for example, it may be formed by a chemical vapor deposition (CVD) method, a physical vapor deposition (PVD) method, or an atomic layer deposition (ALD) method, etc., on which the present disclosure does not pose any limitation.

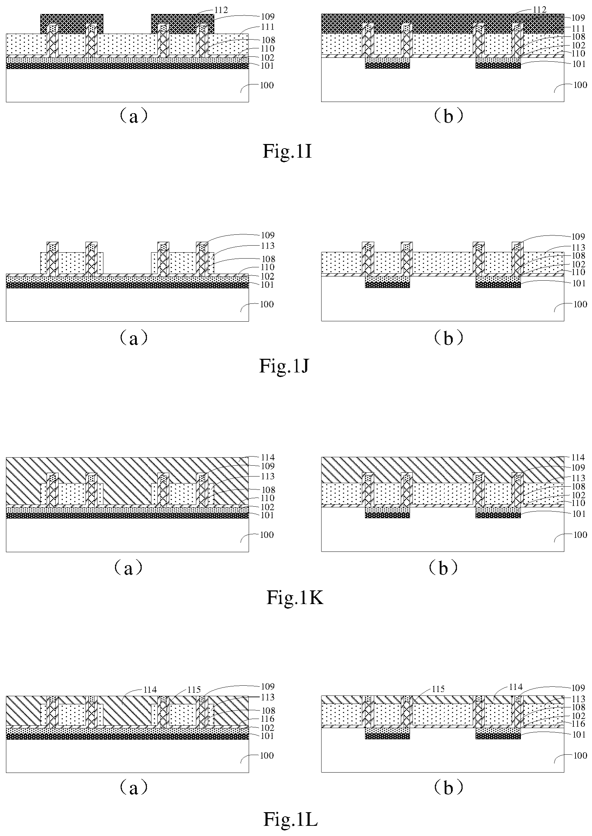

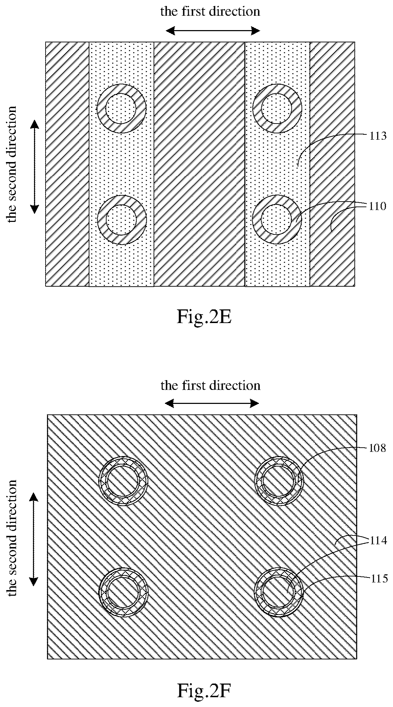

Next, as shown in FIG. 1J and FIG. 2E, the gate electrode material layer 111 is patterned and etched to form a gate electrode 113. Optionally, the surface of the gate electrode 113 on one side away from the substrate 100 is lower than the channel layer 108. Specifically, forming the gate electrode 113 includes: first, as shown in FIG. 1H, etching back to remove part of the gate electrode material layer 111 so that the surface of the gate electrode material layer 111 on one side away from the substrate 100 is lower than the channel layer 108; then, as shown in FIG. 1I and FIG. 2D, forming a second patterned mask layer 112 on the gate electrode material layer 111 for patterning and preparing the gate electrode 113, wherein optionally, the second patterned mask layer 112 extends in the second horizontal direction to simultaneously prepare the gate electrode 113 and the signal line connected to the gate electrode 113, such as the word line WL; finally, as shown in FIG. 1J, using the second patterned mask layer 112 as a mask to etch and remove the exposed remaining gate electrode material layer 111 to form the gate electrode 113. Exemplarily, the material of the gate electrode 113 includes but is not limited to tungsten, polysilicon, doped polysilicon, tantalum nitride, tantalum, copper, and the like.

Next, as shown in FIG. 1K, an insulating dielectric layer 114 is prepared and covers the gate insulating material layer 110 and the gate electrode 113. Exemplarily, the insulating dielectric layer 114 may be formed by a deposition method commonly used in the art, for example, it may be formed by a chemical vapor deposition (CVD) method, a physical vapor deposition (PVD) method, or an atomic layer deposition (ALD) method, etc., on which the present disclosure does not pose any limitation. Exemplarily, the insulating dielectric layer 114 may be made of conventional insulating materials, such as silicon oxide, silicon nitride, silicon oxynitride, and the like, on which the present disclosure does not pose any limitation.

Finally, as shown in FIG. 1L and FIG. 2F, a portion of the insulating dielectric layer 114 and a portion of the gate insulating material layer 110 are removed to expose the upper contact portion 109, wherein the gate insulating material layer located on a side of the gate electrode 113 close to the channel layer 108 is formed as the gate insulating layer 115. Exemplarily, the gate insulating material layer located between the gate electrode 113 and the first electrode becomes the first insulating layer 116. In one embodiment, the removal process is chemical mechanical polish (CMP), with the end point of the polish being the upper contact portion 109, or the polish also removes part of the thickness of the upper contact portion 109. The present disclosure does not impose specific restrictions on the removal process. By configuring the upper contact portion, the side of the channel layer 108 close to the second electrode is avoided from being damaged due to the manufacturing process and affecting the electrical performance.

In one example, in the orthographic projection on the substrate 100, the first patterned mask layer 107 includes a ring, and the gate electrode 113 includes a portion located inside the ring and a portion located outside the ring; or the first patterned mask layer 107 includes a plurality of portions, and the gate electrode surrounds each of the portions. Specifically, since the orthographic projection of the first patterned mask layer 107 on the substrate 100 is the same as the orthographic projection of the channel layer 108 on the substrate 100, the orthographic projection of the channel layer 108 on the substrate 100 can be used to represent the orthographic projection of the first patterned mask layer 107 on the substrate 100.

In one example, as shown in FIG. 3A, the orthographic projection of the channel layer 108 on the substrate 100 includes a ring, and the orthographic projection of the gate electrode 113 on the substrate 100 includes a third portion 130 located inside the ring and a fourth portion 140 located outside the ring.

In one example, as shown in FIGs. 3D to 3F, the orthographic projection of the channel layer 108 on the substrate 100 includes a plurality of fifth portions 150, the gate electrode 113 includes a sixth portion 160 surrounding each of the fifth portions 150, and the sixth portion 160 in the gate electrode 113 is formed integrally. Specifically, as shown in FIGs. 3D, 3E and 3F, the orthographic projections of the fifth portions 150 on the substrate 100 are strip-shaped and parallel to each other; or, as shown in FIG. 3C, the orthographic projections of the fifth portions 150 on the substrate 100 are rings, and the gate electrode 113 further includes seventh portions 170 located inside the rings. Exemplarily, the orthographic projection of the channel structure on the substrate 100 is completely located within the orthographic projection range of the gate electrode 113 while is at least partially located within the orthographic projection range of the first electrode.

In one example, preparing the second electrode further includes: as shown in FIG. 1N and FIG. 2G, preparing a connection portion 118 at one end of the upper contact portion 109 away from the channel layer 108 after the upper contact portion 109 is exposed, wherein the second electrode further includes the connection portion 118. Specifically, preparing the connection portion 118 includes: as shown in FIG. 1M, first depositing a material layer 117, such as the conductor layer or the contact material layer, for preparing the connection portion 118 on the upper contact portion 109 and the insulating dielectric layer 114; and then patterning the material layer 117 to obtain connection portions 118 disposed independent from each other, as shown in FIG. 1N. Exemplarily, as shown in FIG. 2G, the shape of the connection portion 118 may be circular, or the shape of the connection portion 118 may also be rectangular or long strip, which can be set according to actual needs. Exemplarily, the connection portions 118 above different channel layers 108 are independently disposed, and the connection portions 118 can be used to increase the contact area and reduce the resistance. Exemplarily, the connection portion 118 is independently connected to a storage structure above. Taking a 1T1C unit structure as an example, each connection portion 118 can be connected to a capacitor. Exemplarily, the semiconductor device of the present disclosure is not limited to the 1T1C structure, and can also be applied to memories of other unit structures (for example, 1T3C, 2T0C, etc.), on which the present disclosure does not pose any limitation. Exemplarily, the first electrode is equivalent to the source electrode of the transistor, the gate electrode 113 is equivalent to the gate electrode of the transistor, and the second electrode can serve as the drain electrode of the transistor; or another film layer may be formed on the second electrode to serve as the drain of the transistor; or it is also possible not to form the film layer that serves as the drain of the transistor, and the second electrode (the connection portion 118 in the second electrode) may be directly connected to the capacitor (taking the 1T1C unit structure as an example).

In one example, the semiconductor device of the present disclosure may further include a storage structure located on the second electrode and electrically connected to the second electrode to constitute a storage unit. The storage units are arranged in an array to form a memory. Taking the 1T1C unit structure as an example, when it is necessary to read the information stored in a certain unit structure, it only needs to pass a high level to the word line of the unit, and the level state of the capacitor of the unit will be added to the corresponding bit line. The bit line is connected to the read-write drive circuit, and the level state of the capacitor can be read by the read-write drive circuit to complete the reading of the information; or the read-write drive circuit outputs a high level or a low level to charge or discharge the capacitor to complete the writing of the information.

The description of the key steps of the method for manufacturing the semiconductor device of the present disclosure has been completed. The preparation of a complete semiconductor device may further include other steps, which will not be repeated here. It is worth mentioning that the above steps are only used as examples, and the order of the above steps can be adjusted without conflict.

Given above, the method for manufacturing the semiconductor device of the present disclosure advances the process of the channel layer, forms the channel layer first, and then forms the gate electrode, which can improve the crystallization characteristics of the channel layer while improve the shape structures of the channel layer, so that the channel layer is no longer limited to a circular ring shape, which can increase the channel area, facilitate improving electric leakage and increasing the working current, and thereby enhance the electrical performance of the semiconductor device.

Although multiple embodiments are described herein, it is to be understood that a variety of other modifications and embodiments may be conceived by those skilled in the art, all of which will fall within the spirit and scope of the concepts disclosed herein. More particularly, various modifications and changes may be made to the arrangements and/or components of the combined arrangements of the subject matter within the scope of the disclosure, drawings, and appended claims of the present disclosure. In addition to modifications and changes to the components and/or arrangements, the use of alternatives is also an obvious option for those skilled in the art.

## Claims

1. A semiconductor device, comprising:
a substrate (100) and a semiconductor component located on the substrate (100);
wherein the semiconductor component comprises a channel structure and a first electrode, a gate electrode (113) and a second electrode, the first electrode, the gate electrode (113) and the second electrode are spaced apart and stacked sequentially in a vertical direction, the channel structure comprises a channel layer (108) and a gate insulating layer (115), the channel structure extends through the gate electrode (113) in the vertical direction and is connected between the first electrode and the second electrode, and the gate insulating layer (115) is located between the gate electrode (113) and the channel layer (108).

2. The semiconductor device of claim 1, further comprising a first insulating layer (116) prepared in the same layer as the gate insulating layer (115) and extending horizontally between the first electrode and the gate electrode (113);
wherein the first insulating layer (116) is in contact with the first electrode, and the first insulating layer (116) is in contact with the gate electrode (113).

3. The semiconductor device of claim 1, wherein:
a distance between an end of the channel layer (108) connected to the second electrode and the gate electrode (113) is smaller than a distance between an end of the gate insulating layer (115) in contact with the second electrode and the gate electrode (113);
the second electrode comprises a first portion in contact with the channel layer (108), and a second portion located on a side of the first portion away from the channel layer (108); and
the semiconductor device further comprises an insulating dielectric layer (114) located between the second portion and the gate electrode (113), and an orthographic projection of the insulating dielectric layer (114) on the substrate (100) does not overlap with an orthographic projection of the channel structure on the substrate (100).

4. The semiconductor device of claim 1, wherein:
the semiconductor device further comprises a first signal line (122) formed integrally with the first electrode and extending in a first horizontal direction, and an orthographic projection of the first electrode on the substrate (100) is located within an orthographic projection of the first signal line (122) on the substrate (100); and
an orthographic projection boundary of the channel layer (108) on the substrate (100) exceeds the orthographic projection of the first signal line (122) on the substrate (100); or
an orthographic projection boundary of the channel layer (108) on the substrate (100) partially overlaps with an edge of the orthographic projection of the first signal line (122) on the substrate (100) and does not exceed the orthographic projection of the first signal line (122).

5. The semiconductor device of claim 1, wherein:
an orthographic projection of the channel structure on the substrate (100) comprises a ring, and an orthographic projection of the gate electrode (113) on the substrate (100) comprises a third portion (130) located inside the ring and a fourth portion (140) located outside the ring.

6. The semiconductor device of claim 1, wherein:
an orthographic projection of the channel structure on the substrate (100) comprises a plurality of fifth portions (150); the gate electrode (113) comprises a sixth portion (160) surrounding each of the fifth portions (150), and the sixth portion (160) in the gate electrode (113) is formed integrally; and
wherein:
orthographic projections of the fifth portions (150) on the substrate (100) are strip-shaped and parallel to each other; or
orthographic projections of the fifth portions (150) on the substrate (100) are rings, and the gate electrode (113) further comprises seventh portions (170) located inside the rings.

7. The semiconductor device of claim 1, wherein:
the first electrode comprises a first contact material layer (102) and a conductor layer (101), wherein the first contact material layer (102) is disposed between the conductor layer (101) and the channel layer (108); and
the second electrode comprises a second contact material layer (109).

8. A method for manufacturing a semiconductor device, comprising the steps of:
providing a substrate (S1); and
sequentially preparing a first electrode, a channel layer, a gate insulating layer and a gate electrode on the substrate, and preparing a second electrode on the substrate (S2);
wherein the channel layer extends in a vertical direction and is connected between the first electrode and the second electrode, and the gate insulating layer is located between the gate electrode and the channel layer.

9. The method of claim 8, wherein preparing the channel layer comprises:
preparing a semiconductor material layer on the first electrode;
preparing a first patterned mask layer on the semiconductor material layer; and
using the first patterned mask layer as a mask to etch the semiconductor material layer to form the channel layer;
wherein:
the first patterned mask layer comprises at least one portion, and an orthographic projection of the portion on the substrate comprises a ring or a rectangle; and/or
an orthographic projection of the first patterned mask layer on the substrate comprises a plurality of parallel strips.

10. The method of claim 9, wherein preparing the second electrode comprises:
preparing a contact material layer on the semiconductor material layer before preparing the first patterned mask layer; and
patterning the contact material layer to form an upper contact portion while etching the semiconductor material layer using the first patterned mask layer as a mask;
wherein the second electrode comprises the upper contact portion.

11. The method of claim 10, the method further comprises:
preparing a first signal line, the first signal line and the first electrode being prepared simultaneously, and an orthographic projection of the first electrode on the substrate being located within an orthographic projection of the first signal line on the substrate;
preparing the gate insulating layer and the gate electrode comprises:
preparing a gate insulating material layer that covers the channel layer, the upper contact portion, the first electrode and the first signal line;
preparing a gate electrode material layer that covers the gate insulating material layer;
patterning and etching the gate electrode material layer to form the gate electrode, wherein a surface of a side of the gate electrode away from the substrate is lower than the channel layer; and
preparing an insulating dielectric layer that covers the gate insulating material layer and the gate electrode; and
removing a portion of the insulating dielectric layer and a portion of the gate insulating material layer to expose the upper contact portion, wherein the gate insulating material layer located on a side of the gate electrode close to the channel layer is formed as the gate insulating layer; wherein the preparing the second electrode further comprises:
preparing a connection portion at an end of the upper contact portion away from the channel layer after the upper contact portion is exposed, wherein the second electrode further comprises the connection portion.

12. The method of claim 9, wherein, in an orthographic projection on the substrate:
when the first patterned mask layer comprises the ring, the gate electrode comprises a portion located inside the ring and a portion located outside the ring; or
when the first patterned mask layer comprises a plurality of portions, the gate electrode surrounds each of the portions.

13. The method of claim 9, further comprising:
preparing a first signal line, the first signal line and the first electrode being prepared simultaneously, and an orthographic projection of the first electrode on the substrate being located within an orthographic projection of the first signal line on the substrate;
wherein an orthographic projection boundary of the first patterned mask layer on the substrate exceeds the orthographic projection of the first signal line on the substrate, or partially overlaps with an edge of the orthographic projection of the first signal line without exceeding the orthographic projection of the first signal line.

14. The method of claim 9, wherein the first electrode comprises a conductor layer and a lower contact portion located on a side of the conductor layer away from the substrate;
after preparing the semiconductor material layer, the method further comprises the step of:
performing heat treatment so as to reduce impedance between the semiconductor material layer and the lower contact portion.

15. The method of claim 10, wherein:
after preparing the contact material layer on the semiconductor material layer, the method further comprises the step of:
performing heat treatment so as to reduce impedance between the semiconductor material layer and the contact material layer.
